# EUROPEAN PATENT APPLICATION

(11) **EP 2 213 595 A1**
(43) Date of publication of application: **04.08.2010**
(21) Application number: 08839220.4
(22) Date of filing: 29.09.2008
(51) Int. Cl.: B65G 49/06, C23C 14/56, C23C 16/44, H01L 21/205, H01L 21/3065, H01L 21/677

(54) **SUBSTRATE PROCESSING APPARATUS**

(30) Priority: 19.10.2007 JP 2007272694
(71) Applicant: Evatech Co., Ltd., Kuze-gun Kyoto 613-0024 (JP)
(72) Inventor: INO, Eiji, Kuze-gun Kyoto 613-0024 (JP); WATANABE, Akira, Kuze-gun Kyoto 613-0024 (JP); ASHIDA, Hajime, Kuze-gun Kyoto 613-0024 (JP)
(74) Representative: Ludewigt, Christoph
(86) International application number: PCT/JP2008/002708
(87) International publication number: WO 2009/050849

(57) **Abstract**

The present invention provides a substrate processing apparatus capable of achieving space saving and cost reduction.

That is, the present invention provides a substrate processing apparatus for carrying a substrate W in a standing position and performing a predetermined process to the substrate W, including: a plurality of substrate processing chambers 230, 240, and 250; and a common carrying delivery chamber 220 for carrying a substrate to each of the substrate processing chambers, where: at least one of the substrate processing chambers 230, 240 and 250 is provided above or below the common carrying delivery chamber 220; and a substrate passage opening through which the substrate W can pass is provided at the boundaries between the processing chambers and the carrying chamber 220.

## Description

### TECHNICAL FIELD

The present invention relates to a substrate processing apparatus including the substrate holding mechanism for performing predetermined processes to substrates such as glass substrates.

### BACKGROUND ART

In the process of manufacturing semiconductors, liquid crystals, thin-film photovoltaic cells, or other products, a substrate processing apparatus is used to perform one or more processes of a chemical vapor deposition (CVD) process, sputtering process, dry-etching process, and other processes on a substrate. Such a substrate processing apparatus generally includes a substrate carrying mechanism for carrying a substrate to each of the processing chambers and taking it out from the chamber in the apparatus. In such a substrate carrying mechanism, substrates are generally carried in a horizontal position. However, with the recent growth in the screen size of flat-panel displays and the growth in the area of photovoltaic cells, the size of a glass substrate, which is a main element of these products, is becoming larger, and this causes problems: For example, a substrate which is bent by its own weight can be damaged and a larger area is required to install the substrate processing apparatus.

To solve such problems, substrate processing apparatuses in which a substrate is carried and processed in a vertical position have been recently devised. For example, Patent Document 1 discloses a substrate processing apparatus including a mechanism for individually carrying flat panels in an oblique position. Such a configuration can reduce the deflection of a glass substrate to prevent a breakage of the substrate, and can reduce the occupation area of the carrier line.

Patent Document 1 also discloses a system in which the carrier line and a production line including a plurality of processing units are vertically separated. For example, this system has main processing units arranged on the upper level and the carrier line and some processing units on the lower level, with a lifter provided to carry up or down a substrate between the carrier line and the processing units on the upper level. Arranging some processing units above the carrier line in this manner can further reduce the occupation area of the entire substrate processing apparatus.

[Patent Document 1] Japanese Unexamined Patent Application Publication No. 2003-192127 ([0013], [0031], and Figs. 8 and 9)

### DISCLOSURE OF THE INVENTION

### PROBLEM TO BE SOLVED BY THE INVENTION

In the substrate processing apparatus described in Patent Document 1, a substrate is lifted by the lifter to the level where the processing units are located, and then carried into a processing unit from the front side. After that, the processed substrate taken out from the back of the processing unit is lowered to a common carrying delivery chamber by another lifter. Therefore, it is necessary to provide spaces for holding the lifters before and after each processing unit. That is, the processing units are required to be widely spaced from each other, which hinders the reduction of the occupation area of the entire apparatus. Another disadvantage of this apparatus is the necessity of providing two lifters for every processing unit: one for carrying in a substrate and the other for taking it out, which increases the equipment cost.

Given these factors, the problem to be solved by the present invention is to provide a substrate processing apparatus capable of achieving space saving and cost reduction.

### MEANS FOR SOLVING THE PROBLEM

To solve the previously described problems, the present invention provides a substrate processing apparatus for carrying a substrate in a standing position and performing a predetermined process to the substrate, including:
a) a plurality of substrate processing chambers; and
b) a common carrying delivery chamber for carrying the substrate to each of the substrate processing chambers, where:
   at least one of the substrate processing chambers is provided above or below the common carrying delivery chamber; and
   a substrate passage opening through which the substrate can pass is provided at the boundary between the aforementioned one of the substrate processing chambers and the common carrying delivery chamber.

In the above-described substrate processing apparatus according to the present invention, the common carrying delivery chamber and at least some substrate processing chambers are arranged one above the other. The substrate processing chambers can be provided either above or below the common carrying delivery chamber. The "standing position" means a condition in which a given angle is made to the horizontal plane. That is, a substrate may be obliquely inclined. However, to save space, the substrate may preferably be perpendicular to the horizontal plane. This position is particularly referred to as a "vertical position."

In the above-described substrate processing apparatus according to the present invention, at least one substrate passage opening preferably can be opened or closed by a gate valve.

In addition, in the above-described substrate processing apparatus according to the present invention, a substrate carrying means is preferably provided in the common carrying delivery chamber, and the substrate carrying means is capable of horizontally carrying a substrate in the standing position in the common carrying delivery chamber and capable of vertically carrying the substrate between the common carrying delivery chamber and the substrate processing chambers.

Furthermore, in the above-described substrate processing apparatus according to the present invention, a substrate in a vertical position is preferably carried in the direction orthogonal to the direction of the thickness of the substrate in the common carrying delivery chamber.

### EFFECTS OF THE INVENTION

In the substrate processing apparatus of the present invention having the aforementioned configuration, the substrate processing chambers and the common carrying delivery chamber are vertically arranged, and substrates are carried in and out between the substrate processing chambers and the common carrying delivery chamber through the substrate passage opening provided on their boundary, i.e. the floor or ceiling of the substrate processing chambers. Therefore, it is not necessary to provide spaces for carrying in or out a substrate before and after each substrate processing chamber, which can further save space. Furthermore, since substrates can be carried into or taken out from the substrate processing chambers by one carrier mechanism, the equipment cost can be moderated.

With the substrate carrying means capable of carrying a substrate horizontally and vertically as previously described, the substrate is carried inside the common carrying delivery chamber and carried in or out from the substrate processing chamber by one carrier mechanism. Therefore, compared to the case where the former carrying operation and the latter carrying operation are performed by different carrying apparatuses, the manufacturing cost and the maintenance cost of the carrying apparatus can be further reduced.

If, as previously described, a substrate in a vertical position is carried in the direction orthogonal to the direction of the thickness of the substrate in the common carrying delivery chamber, the volume of the common carrying delivery chamber can be reduced. Consequently, the common carrying delivery chamber can be vacuumed by a relatively inexpensive and small-capacity vacuum pump, reducing the equipment cost. The size reduction of the common carrying delivery chamber not only decreases the installation area of the apparatus but makes the apparatus lighter since the number of reinforcement members or similar elements for ensuring pressure resistance can be minimized. Further advantageously, since the surface area of the inner walls of the carrying chamber is reduced, the amount of outgassing from the inner walls of the carrying chamber in the course of a vacuuming process can be reduced.

### BRIEF DESCRIPTION OF THE DRAWINGS

Fig.1 (a) is a plain view of the schematic configuration of a substrate processing apparatus according to an embodiment of the present invention, and Fig. 1(b) is a sectional view at line A-A' of Fig. 1(a).
Fig. 2(a) is a top view of the configuration of a roller conveyer in the substrate processing apparatus of the same embodiment, and Fig. 2(b) is a side view of the same.
Fig. 3 is a side view showing the state in which substrates are mounted in a horizontal position on the conveyer.
Fig. 4 is a side view showing the state in which the conveyer is in the standing position.
Fig. 5 is a front sectional view showing a load lock chamber with substrates carried therein.
Fig. 6 is a sectional view at line A-A' of Fig. 5.
Fig. 7 is a front sectional view showing a procedure in which substrates are carried into the common carrying delivery chamber from the load lock chamber.
Fig. 8(a) is a front view showing the configuration of a carrier, and Fig 8(b) is a sectional view at line A-A' of Fig. 8(a).
Fig. 9(a) is a front view of a substrate holding roller in the substrate holding state, and Fig. 9(b) is a side view of the same.
Fig. 10(a) is a front view of a substrate holding roller in the holding release state, and Fig. 10(b) is a side view of the same.
Fig. 11 is a front sectional view showing a state in which the delivery to the carrier has started.
Fig. 12 is a sectional view at line A-A' of Fig. 11.
Fig. 13 is a sectional view showing a delivery process to the carrier.
Fig. 14 is a sectional view showing a state in which the delivery to the carrier has finished.
Fig. 15 is a front sectional view showing a process in which substrates are carried into a preheating chamber.
Fig. 16(a) is a side sectional view showing a process in which substrates are carried into a preheating chamber, where rollers have been withdrawn, and Fig. 16(b) is the same where the rollers have been returned to the holding positions.
Fig. 17 is a front sectional view showing a state in which substrates are moved immediately below a deposition chamber.
Fig. 18(a) is a side sectional view showing a process in which substrates are carried into the deposition chamber, where rollers have been withdrawn, and Fig. 18(b) is the same where the rollers have been returned to the holding positions.

### EXPLANATION OF NUMERALS

- 110: Roller Conveyer
- 120,214,222: Standing Carrier Roller
- 210, 260: Load Lock Chamber
- 211, 212, 241, 261, 262: Gate Valve
- 213,221,231: Substrate Holding Plate
- 214, 222: Standing Carrier Roller
- 220: Common Carrying Delivery Chamber
- 221a: Upper Plate
- 226: Rail
- 230: Preheating Chamber
- 231a: Lower Plate
- 240: Deposition Chamber
- 250: Cooling Chamber
- 270: Carrier
- 271: Substrate Holder
- 272: Traveling Base
- 274: Pantograph Mechanism
- 280: Substrate Holding Roller
- W: Substrate

### BEST MODE FOR CARRYING OUT THE INVENTION

Hereinafter, an embodiment of a substrate processing apparatus according to the present invention will be described with reference to the attached figures.

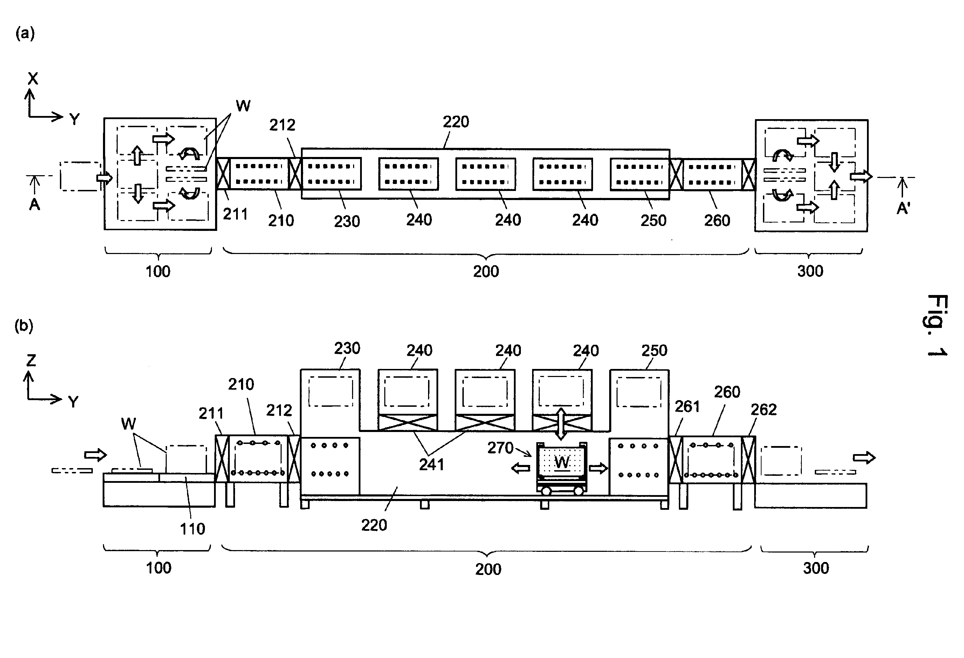

Fig. 1 is a schematic configuration of the substrate processing apparatus according to the present embodiment. The substrate processing apparatus according to the present embodiment is a plasma enhanced chemical vapor deposition (PE-CVD) apparatus for forming a thin film on a substrate by the PE-CVD technique. This apparatus is broadly composed of: a load section 100; a processing unit 200; and an unload section 300.

The processing unit 200 is composed of: a preheating chamber 230 for preheating a substrate W in advance of processing; a plurality of deposition chambers 240 for forming different thin films; a cooling chamber 250 for cooling the substrate W after processing; load lock chambers 210 and 260 for carrying the substrate into the processing unit 200 and taking it out therefrom; and a common carrying delivery chamber 220 having a carrier 270 for carrying the glass substrate W into these chambers. In the present embodiment, the preheating chamber 230, deposition chambers 240, and cooling chamber 250 fall into the "substrate processing chambers" according to the present invention.

All of the preheating chamber 230, deposition chambers 240, and cooling chamber 250 (which will hereinafter be arbitrarily and collectively called the "substrate processing chambers") are placed above the common carrying delivery chamber 220. At the boundaries between these substrate processing chambers 230, 240, and 250 and the common carrying delivery chamber 220, i.e. on each floor of the substrate processing chambers 230, 240, and 250, an opening through which the substrate W can pass is provided (this opening corresponds to the "substrate passage opening" of the present invention). Through these openings, the substrate W is carried in or taken out between the common carrying delivery chamber 220 and each of the substrate processing chambers 230, 240, and 250.

Similar openings are also provided at the boundaries between the common carrying delivery chamber 220 and the load lock chambers 210 and 260, and at the boundaries between the load lock chambers 210 and 260 and the outside of the processing unit 200. At these openings, excluding the opening at the boundaries between the preheating chamber 230 and the common carrying delivery chamber 220 and the opening between the cooling chamber 250 and the common carrying delivery chamber 220, gate valves 211, 212, 241, 261, and 262 which can be individually opened or closed are provided. The deposition chambers 240 and the common carrying delivery chamber 220 are each maintained in vacuum by a vacuum pump which is not shown. The load lock chambers 210 and 260 are pre-vacuum chambers for temporarily holding the substrates W carried from the load section 100 and the substrates W to be carried to the unload section 300, respectively. The load lock chambers 210 and 260 can be evacuated by the vacuum pump when needed.

The load section 100 has roller conveyers for carrying the substrates W carried from the previous process into the load lock chamber 210. After being carried into the load section in a horizontal position, the substrates W to be processed are directed alternately leftward and rightward (in the X-axis direction in Fig. 1) by a substrate directing mechanism (not shown), and are carried by the roller conveyers to substrate standing positions at right and left sides in front of the load lock chamber 210. Similar roller conveyers are provided in the unload section 300, and the substrates W taken out from the load lock chamber 260 are delivered to the subsequent process by these roller conveyers.

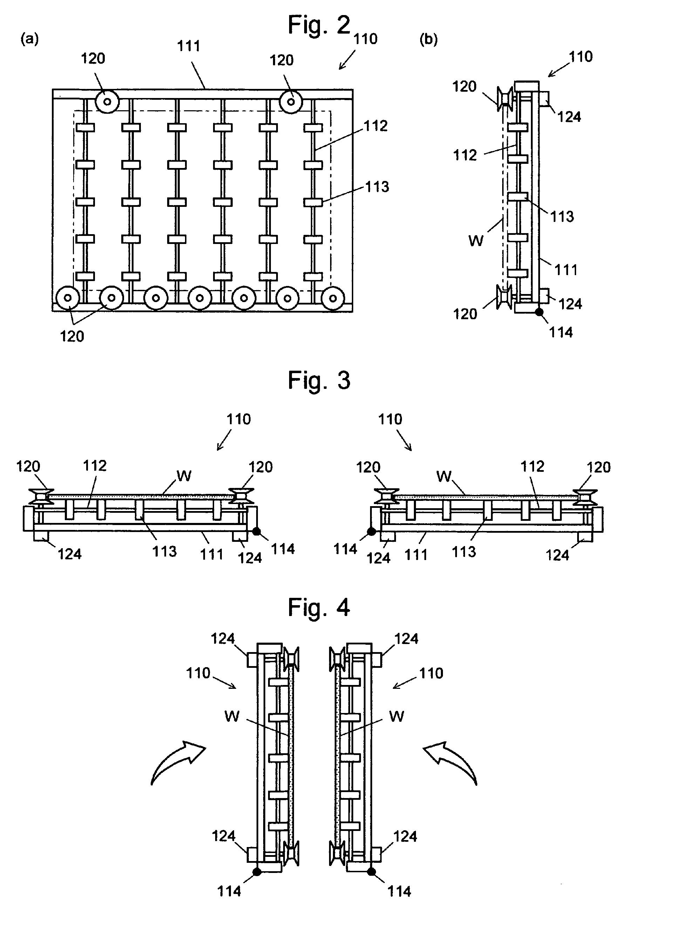

Hereinafter, a detailed description of the roller conveyers will be given. The roller conveyers provided in the load section 100 are for carrying, in a horizontal position, the glass substrates W received from the previous process. The roller conveyers 110 at the substrate standing positions are particularly different from other roller conveyers in other positions. The configuration of the roller conveyer 110 is illustrated in Fig. 2. The roller conveyer 110 has a frame 111 and a plurality of shafts 112 whose both ends are rotatably supported by the frame 111. A plurality of sleeves 113 are attached to each of the shafts 112. By rotating each shaft 112 by a provided driving means (not shown), the substrate W lying on the sleeves 113 can be carried in a specific direction. The frame 111 can be rotated around a rotation axis 114 and can be stood vertically to the ground by a provided driving mechanism (not shown).

In the frame 111, bobbin-shaped standing carrier rollers 120 are attached at positions corresponding to the right and left sides of the substrate W (i.e. the upper and lower sides when the substrate W is in an upright position). The standing carrier roller 120 is composed of: a cylinder part with an integrally formed rotation shaft; and holding flanges provided at both ends of the cylinder part to prevent the substrate W from dropping off. Each rotation shaft of the rollers is connected to one of the roller drivers 124, each of which is provided on the frame 111. Each standing carrier roller 120 is rotated in a specific direction by the roller drivers 124 while the frame 111W is in a standing position: accordingly, the substrate W held by the upper and lower standing carrier rollers 120 can be moved along the arranging direction of the rollers 120.

Next, a procedure for delivering the substrate W from the roller conveyer 110 to the load lock chamber 210 will be described. First, two glass substrates W to be processed are each carried to the substrate standing position by the roller conveyers in the load section 100. Fig. 3 is a side view showing the roller conveyers 110 at this point at the substrate standing positions.

Subsequently, as illustrated in Fig. 4, each roller conveyer 110 is rotated around the rotation axis 114 so that the substrates W mounted on each conveyer face each other to be parallel to one another and vertical to the ground. At this point, since the upper and lower sides of the substrates W are held by the flanges of each of the standing carrier rollers 120, the substrates W do not drop off from the roller conveyers 110 when the roller conveyers 110 are set upright.

After that, the atmosphere-side gate valve 211 is opened while the vacuum-side gate valve 212 is closed in the load lock chamber 210, and each standing carrier roller 120 in the roller conveyers 110 is rotated in a specific direction. Consequently, each substrate W on the roller conveyers 110 is sent out toward the load lock chamber 210, being carried into the inside of the load lock chamber 210 through the atmosphere-side gate valve 211 in an open state. After the substrates W are carried in, the atmosphere-side gate valve 211 in the load lock chamber 210 is closed, and the inside of the load lock chamber 211 is evacuated to the vacuum state by the vacuum pump.

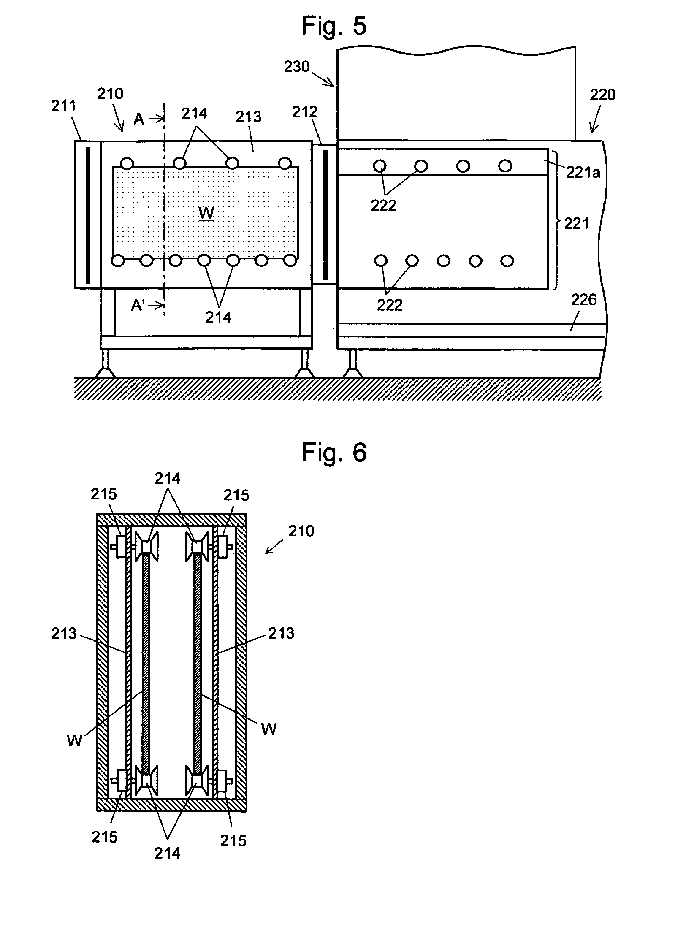

Fig. 5 is a front sectional view showing the load lock chamber 210 when the substrates W have been carried in, and Fig. 6 is a sectional view at line A-A' of Fig. 5. The load lock chamber 210 includes two substrate holding plates 213 facing each other, each plate having a plurality of standing carrier rollers 214 as described earlier. When the substrates W are carried into the load lock chamber 210, both upper and lower sides of the substrates W are supported by the standing carrier rollers 214, so that the substrates W are held on the substrate holding plates 213. Each rotation shaft of the standing carrier rollers 214 is connected to one of the roller drivers 215, which are provided on each of the substrate holding plates 213. By rotating each roller 214 in a specific direction by the roller drivers 215, the substrates W on the substrate holding plates 213 can be carried toward the common carrying delivery chamber 220 (i.e. rightward in Fig. 5).

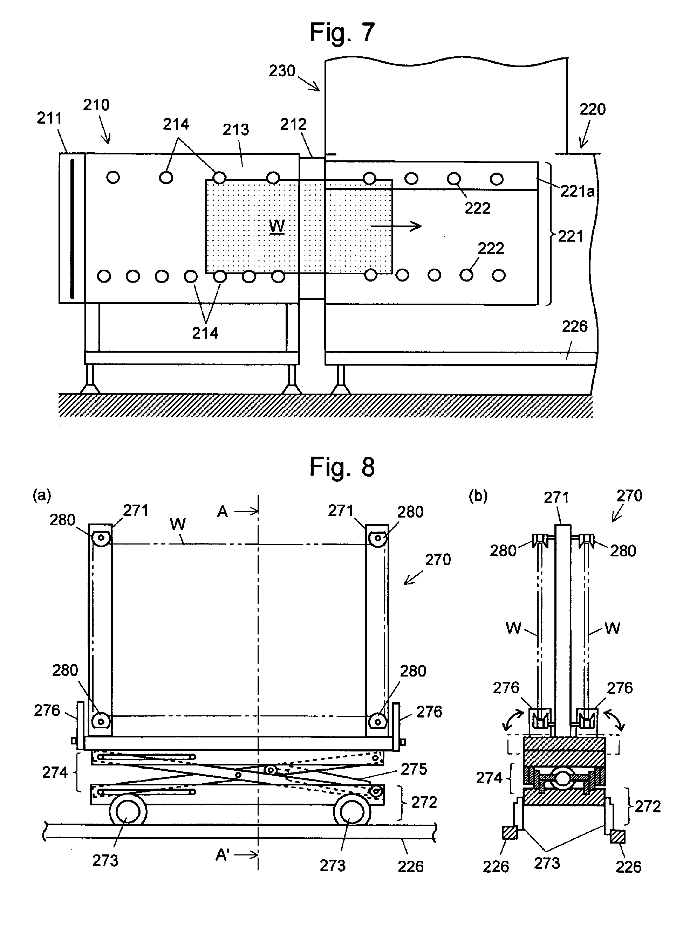

When the inside of the load lock chamber 210 has reached a predetermined vacuum degree, the vacuum-side gate valve 212 in the load lock chamber 210 is opened, and the standing carrier rollers 214 on the substrate holding plates 213 are rotated to send the substrates W to the common carrying delivery chamber 220 (Fig. 7).

In the common carrying delivery chamber 220, two substrate holding plates 221 are provided as in the load lock chamber 210. When the substrates W enter the common carrying delivery chamber 220, their upper and lower ends are supported by the standing carrier rollers 222 on the substrate holding plates 221. As the rollers 222 rotate, the substrates W are further introduced into the common carrying delivery chamber 220.

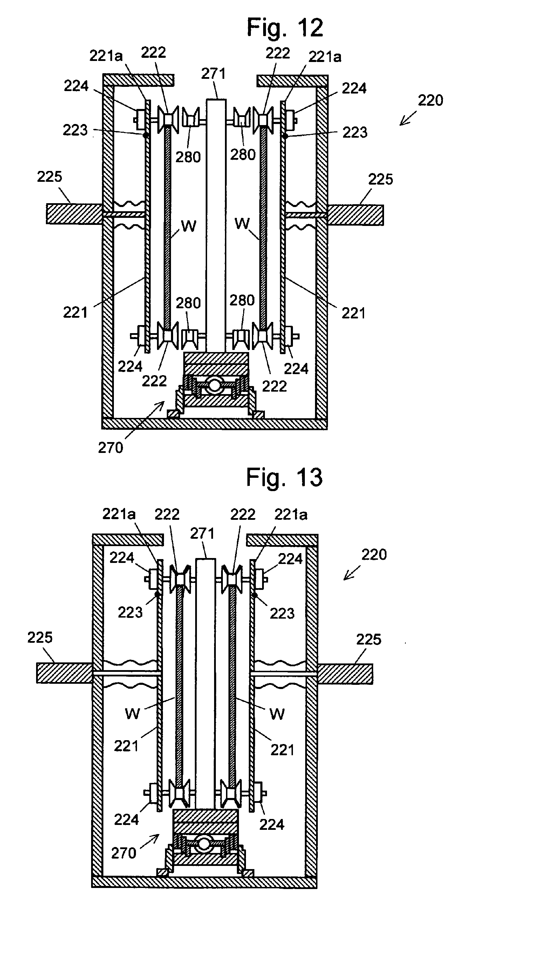

As illustrated in Figs. 12 through 14, each of the substrate holding plates 221 can be moved closer to or away from each other in a specific direction (i.e. in the X-axis direction in Fig. 1) by cylinders 225 provided outside of the common carrying delivery chamber 220. Each substrate holding plate 221 in the common carrying delivery chamber 220 is composed of upper and lower plates which are pivotally connected through a rotation shaft 223. By rotating the upper plate 22 1 a around the rotation shaft 223 toward the outside of the common carrying delivery chamber 220, the rollers 222 attached to the upper plate 221 a (i.e. the standing carrier rollers for the upper side of a substrate) can be moved between the holding position for holding the upper end of the substrate W and the withdrawal position where the rollers are withdrawn from the upside of the substrate W (i.e. from the passage of the substrate W while it is lifted up or lowered down). The details will be described later.

Next, the substrates held by the substrate holding plates 221 are delivered to the carrier 270 provided in the common carrying delivery chamber 220. Fig. 8 shows the configuration of the carrier 270. The carrier 270 is for carrying a substrate in a vertical position in the direction orthogonal to its thickness direction and includes: a traveling base 272 having tires for running on rails 226 laid in the common carrying delivery chamber 220; a substrate holder 271 mounted above the traveling base 272; and a pantograph mechanism 274 stretchably connected between the traveling base 272 and the substrate holder 271. By elongating or contracting the pantograph mechanism 274 by an electric cylinder 275, the substrate holder 271 can be vertically moved on the traveling base 272. Before and behind the traveling base 272, rotation stoppers 276 for restricting the movement of substrates in the front and back direction (in the Y-axis direction in Fig. 1) are provided. Each of the stoppers 276 can be rotated by a driving mechanism (which is not shown) and, as illustrated in Fig. 8(b), can be arbitrarily withdrawn to the position where it does not obstruct the substrate.

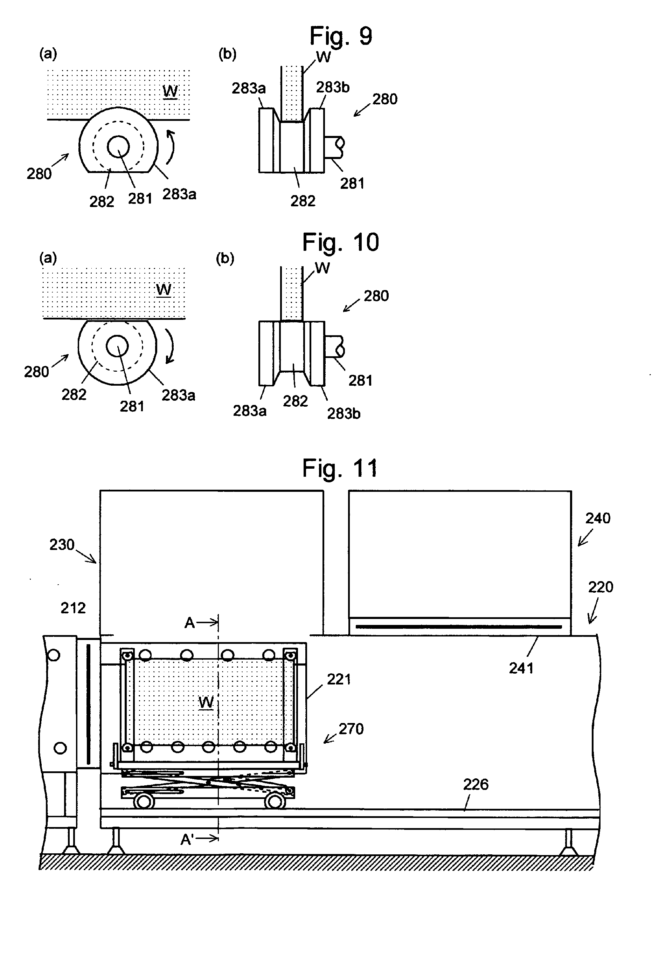

The substrate holder 271 is composed of a pair of vertical arms provided on both front and rear sides above the traveling base 272. On both the front and back sides of each arm, substrate holding rollers 280 as illustrated in Figs. 9 and 10 are attached at the positions corresponding to the upper and lower sides of the substrate W. By holding the upper and lower sides of the substrate W by the rollers, the substrates W can be held in a vertical position, one on the front side and the other on the back side of the pair of arms.

The substrate holding roller 280 has: a cylinder part 282 with an integrally formed rotation shaft 281; and holding flanges 283a and 283b provided along a portion of the circumference of both ends of the cylinder part 282. Each rotation shaft 281 of the rollers is connected to one of roller drivers (not shown), each of which is provided on the substrate holder 271. Each substrate holding roller 280 is rotated by these roller drivers, and in accordance with the rotation angle, the substrate W can be held (Fig. 9) or released (Fig. 10). Hereinafter, the state of Fig. 9 will be referred to as the "substrate holding state," and the state of Fig. 10, as the "holding release state." In the substrate holding state, since the edges of the substrate W lie between both the holding flanges 283a and 283b as illustrated in Fig. 9(b), the movement of the substrate W in its thickness direction is restricted. In the holding release state, the substrate W and the holding flanges 283a and 283b are free from obstructing each other, as shown in Fig. 10(b). Therefore, the movement of the substrate W in its thickness direction is not restricted.

The substrates W can be transferred from the substrate holding plates 221 to the carrier 270 in the common carrying delivery chamber 220 as follows: First, as illustrated in Figs. 11 and 12, the carrier 270 is moved to the space between the two substrate holding plates 221. Next, each of the substrate holding plates 221 is moved to the center of the substrate carrying chamber by the cylinders 225 so as to bring each substrate W on the substrate holding plates 221 closer to the substrate holder 271 of the carrier 270 (Fig. 13). At this point in time, the substrate holding rollers 280 on the substrate holder 271 are in the holding release state. At the same time, the standing carrier rollers 222 on the substrate holding plates 221 and the substrate holding rollers 280 on the substrate holder 271 are provided at the positions where they are free from obstructing each other as illustrated in Fig. 11. Therefore, each substrate W can be moved closer to the substrate holder 271 without any contact between the standing carrier rollers 222 on the substrate holding plates 221 and the substrate holding rollers 280 on the substrate holder 271 as well as any contact between the substrate holding rollers 280 on the substrate holder 271 and the substrate W.

After that, the substrate holding rollers 380 on the substrate holder 271 of the carrier 270 are rotated to be in the substrate holding state. Accordingly, each substrate W is held by both the standing carrier rollers 222 on the substrate holding plates 221 and the substrate holding rollers 280 on the substrate holder 271.

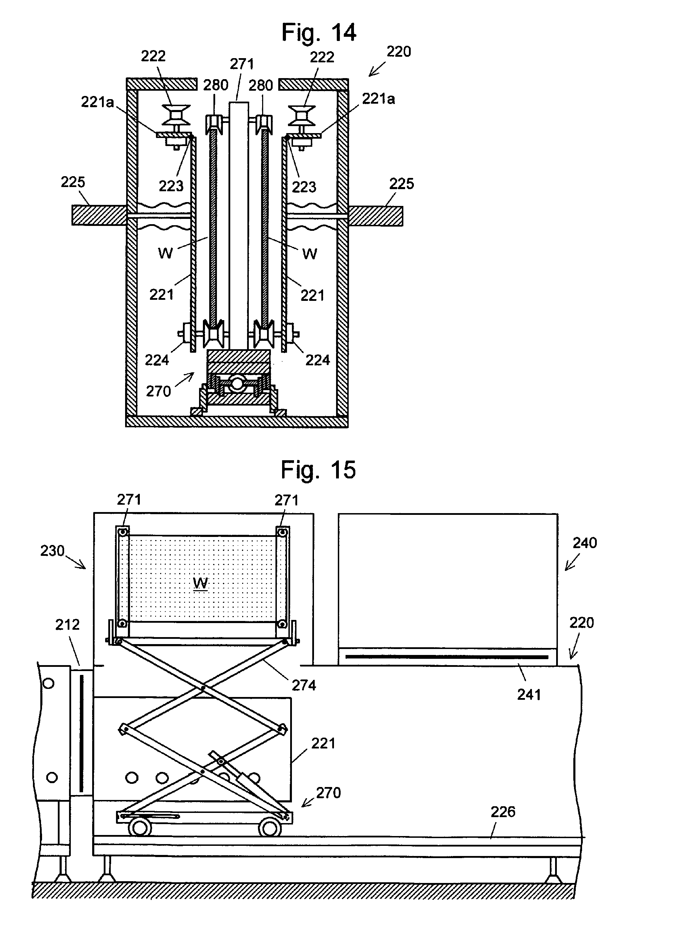

Next, the upper plates 221a of each of the substrate holding plates 221 rotate outward around the rotation shaft 223, so that the standing carrier rollers 222 which were holding the upper side of the substrates W move to the withdrawal positions (Fig. 14). Then, the pantograph mechanism 274 stretches to lift the substrate holder 271, so that the two substrates W mounted on the substrate holder 271 are carried into the preheating chamber 230 which is provided above the common carrying delivery chamber 220 (Fig. 15).

The substrates W carried into the preheating chamber 230 by the aforementioned procedure are delivered from the substrate holder 271 of the carrier 270 to a given substrate holding mechanism provided in the preheating chamber 230.

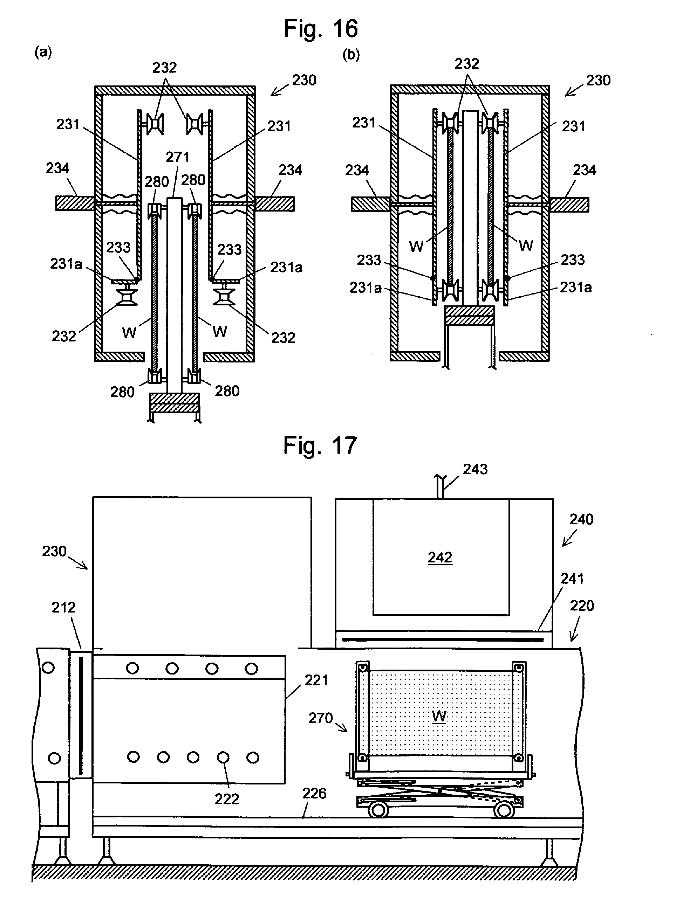

As the substrate holding mechanism, the mechanism illustrated in Fig. 16, for example, can be used. This mechanism is almost the same as the substrate holding plates 221 of the common carrying delivery chamber 220, but provided upside down. With this mechanism, two substrate holding plates 231 can be moved closer to or away from each other by the cylinders 234. Also, by rotating the lower plates 231a of each of the substrate holding plates 231 around the rotation shaft 233 toward the outside of the preheating chamber 230, the rollers 232 for supporting the lower side of the substrates can be withdrawn from the passage of the substrates W. Meanwhile, since the substrates W are not horizontally carried in the preheating chamber 230, the rollers 232 on each of the substrate holding plates 231 do not need to be rotatable.

To carry substrates into the preheating chamber 230 having the substrate holding mechanism as previously described, the rollers 232 attached to the lower plates 231a are first moved to the withdrawal positions, and then the substrate holder 271 of the carrier 270 is made to enter between the two substrate holding plates 231 (Fig. 16(a)). Subsequently, the rollers 232 on the lower plates 231a are returned to the holding positions to hold the substrates W and the substrate holding rollers 280 on the substrate holder 271 are set to be in the holding release state (Fig. 16(b)). After that, each of the substrate holding plates 231 is moved to the outside of the preheating chamber 230 by the cylinders 234, and the pantograph mechanism 274 of the carrier 270 is retracted to lower down the substrate holder 271 to the common carrying delivery chamber 220.

The configuration of the substrate holding mechanism provided in the preheating chamber 230 is not limited to the aforementioned one. For example, two plate members may be provided in the preheating chamber 230, each of the plate members having a plurality of substrate holding rollers as illustrated in Figs. 9 and 10 on one side and capable of holding the upper and lower sides of the substrate W by the substrate holding rollers. These two plate members are arranged to face each other with the side on which the rollers are attached facing inward, and each of the plate members can be moved closer to or away from each other. To carry substrates W into the preheating chamber 230 having such a substrate holding mechanism, the substrate holder 271 of the carrier 270 is first made to enter between the two plate members while the plate members are separated from each other. Then, each plate member is moved closer to the substrate holder 271. Subsequently, the substrate holding rollers of each plate member are set to be in the substrate holding state and the substrate holding rollers 280 of the substrate holder 271 are set to be in the holding release state, so that the substrates W are transshipped from the substrate holding rollers 280 of the substrate holder 271 to the substrate holding rollers on the plate members. Then each of the plate members mounting the substrate W is moved away from each other, and the substrate holder 271 is withdrawn from the preheating chamber 230.

When the process in the preheating chamber 230 is finished, the previously described steps are followed in reverse order so that each glass substrate W is delivered from the substrate holding plate 231 in the preheating chamber 230 to the substrate holder 271 of the carrier 270 to be carried out to the common carrying delivery chamber 220. After that, the traveling base is driven along the rail 226 laid in the common carrying delivery chamber 220 to move the carrier 270 to a point immediately below the subsequent deposition chamber 240, and the substrates W are carried in and out according to the previously described procedure.

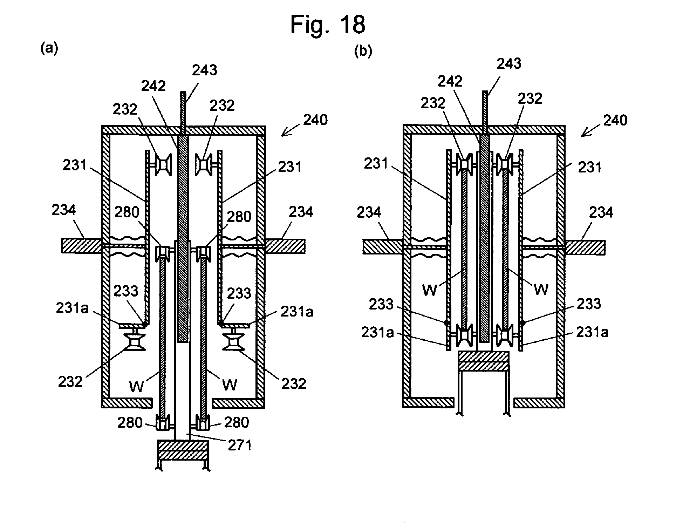

The sectional view of a deposition chamber 240 in this embodiment is shown in Fig. 18. At the center of the deposition chamber 240, an electrode 242 having a feed portion 243 is provided. At the positions facing across the electrode 242, substrate holding plates 231 as in the preheating chamber 230 are provided. The same components as illustrated in Fig. 16 are indicated with the same numerals and the explanations are omitted. The length of the electrode 242 in the front-back direction (or the Y-axis direction in Fig. 1) is smaller than the space between the pair of arms of the substrate holder 271 on the carrier 270. Hence, when the substrate holder 271 is made to enter the deposition chamber 240, the electrode 242 is positioned between these two arms, and therefore the substrate holder 271 and the electrode 242 are free from obstructing each other. The openings between the deposition chambers 240 and the common carrying delivery chamber 220 are normally closed by the gate valves 241. Only when the substrates W are carried in or out, the gate valve 241 is opened so that the substrates W can pass through the opening.

As described thus far, with the substrate processing apparatus according to the present embodiment, each substrate processing chamber is arranged above the common carrying delivery chamber. And, substrates are carried in and out, between the common carrying delivery chamber and the substrate processing chambers, through openings (substrate passage openings) provided on the boundaries provided therebetween, i.e. on the floor of each substrate processing chamber. Therefore, the space between the substrate processing chambers can be reduced, achieving further space saving. In the case where a carrier capable of running in the common carrying delivery chamber and capable of lifting up and lowering down a substrate is provided, both a horizontal carry of the substrates in the common carrying delivery chamber and a vertical carry of the substrates to each of the substrate processing chambers can be performed by one carrier. Hence, the manufacturing cost and the maintenance cost of the carrying apparatus can be reduced as compared to the case where a horizontal carrying apparatus and a virtual carrying apparatus are separately provided. In addition, if substrates in a vertical position are carried in the direction orthogonal to the direction of the thickness of the substrates in the common carrying delivery chamber, the volume of the common carrying delivery chamber can be reduced, allowing further reduction of space, cost, and weight.

## Claims

1. A substrate processing apparatus for carrying a substrate in a standing position and performing a predetermined process to the substrate, comprising:
a) a plurality of substrate processing chambers; and
b) a common carrying delivery chamber for carrying the substrate to each of the substrate processing chambers, where:
at least one of the substrate processing chambers is provided above or below the common carrying delivery chamber; and
a substrate passage opening through which the substrate can pass is provided at a boundary between the aforementioned one of the substrate processing chambers and the common carrying delivery chamber.

2. The substrate processing apparatus according to claim 1, wherein at least one substrate passage opening can be opened or closed by a gate valve.

3. The substrate processing apparatus according to claim 1 or 2, in which a substrate carrying means is provided in the common carrying delivery chamber, the substrate carrying means being capable of horizontally carrying a substrate in a standing position in the common carrying delivery chamber and capable of vertically carrying the substrate between the common carrying delivery chamber and the substrate processing chambers.

4. The substrate processing apparatus according to any one of claims 1 through 3, wherein a substrate in a vertical position is carried in a direction orthogonal to a direction of a thickness of the substrate in the common carrying delivery chamber.
